Europäisches Patentamt

European Patent Office

Office européen des brevets

(11) Publication number: **0 174 845 B1**

# EUROPEAN PATENT SPECIFICATION

(45) Date of publication of patent specification: **22.07.92**    (51) Int. Cl.⁵: **G11C  8/00**

(21) Application number: **85306464.0**

(22) Date of filing: **11.09.85**

(54) **Semiconductor memory device.**

(30) Priority: **11.09.84 JP 188891/84**

(43) Date of publication of application:
**19.03.86 Bulletin  86/12**

(45) Publication of the grant of the patent:
**22.07.92 Bulletin  92/30**

(84) Designated Contracting States:
**DE FR GB**

(56) References cited:
**EP-A- 0 045 063      EP-A- 0 115 128**
**EP-A- 0 115 187      JP-A-59 135 695**
**US-A- 4 044 339      US-A- 4 321 695**
**US-A- 4 586 167**

**IEEE JOURNAL OF SOLID-STATE CIRCUITS,
vol. SC-18, no. 5, October 1983, pages
470-478; IEEE, New York, US, K. FUJISHIMA et
al.: "A 256K dynamic RAM with page-nibble
mode", page 472, left-hand column, line 35 -
right-hand column, line 12**

(73) Proprietor: **FUJITSU LIMITED**
**1015, Kamikodanaka Nakahara-ku
Kawasaki-shi Kanagawa 211(JP)**

(72) Inventor: **Takemae, Yoshihiro**
**8-13-24-303, Akasaka
Minato-ku Tokyo 107(JP)**

(74) Representative: **Fane, Christopher Robin King
et al
HASELTINE LAKE & CO. Hazlitt House 28
Southampton Buildings Chancery Lane
London, WC2A 1AT(GB)**

## Description

The present invention relates to semiconductor memory devices.

In one type of prior art computer system including a computer and a semiconductor memory device, in response to successive individual access requests from the computer to the memory device, successive individual data storage or data reading operations involving individual memory cells of the device can be effected.

This system has a disadvantage in that when continuous accessing of a plurality of data items stored in consecutive memory cells of the memory device is required, address data individually designating such memory cells must be supplied to the memory device, as described later in detail with reference to a specific example. Because of the need to supply such address data, in the prior art semiconductor memory device concerned the access time per memory cell, for continuous accessing of a plurality of data items stored in consecutive memory cells, may be undesirably long.

JP-A-59-135696 discloses a semiconductor memory device in which the access time for continuous accessing of data items in a predetermined group of four memory cells ("nibble") is reduced.

The device concerned may be considered to include: a plurality of memory cells arranged in a matrix of columns, connected with respective column lines of the device, and rows connected with respective row lines of the device; row selection means connected for receiving externally-applied row selection data designating a selected one of the said row lines, and operable in dependence upon that data to activate that selected row line; input/output circuitry connected to the said column lines and having a plurality of control inputs associated respectively with predetermined different groups of the said column lines; and column group selection means connected for receiving externally-applied selection data designating a selected one of the said control inputs, and operable in dependence upon that data to apply a column group selection signal to the said selected one of the control inputs; the said input/output circuitry including a plurality of input/output lines, equal in number to the column lines of each of the said different groups, and being operable upon receipt of such a column group selection signal to connect the column lines of the particular group that is associated with the selected control input respectively to the said input/output lines, thereby to permit parallel transfer of data bits between the said input/output lines and those memory cells of the said plurality that are connected with the said selected row line and are also connected respectively with the column lines of the said particular group.

In this device each of the said different groups of column lines is made up of four column lines so that when a "nibble" mode accessing operation is to be performed, involving four memory cells connected respectively with the column lines of a particular group, only a single item of address data, designating that particular group and the row line to which those cells are also connected, need be supplied to the device, thereby affording a reduction in the access time per memory cell.

However, in this device the groups of column lines are mutually exclusive, no member of one group being also a member of another group. Thus, if it is desired to access data in four memory cells that are not connected respectively with the column lines of a particular group, for example in a case where there are two cells connected with the column lines of a first group and two cells connected with the column lines of a second group, two separate nibble-mode accessing operations must be performed, on the said first and second groups respectively, to access the required memory cells.

According to the present invention there is provided a semiconductor memory device including:

a plurality of memory cells arranged in a matrix of columns, connected with respective column lines of the device, and rows connected with respective row lines of the device;

row selection means connected for receiving externally-applied row selection data designating a selected one of the said row lines, and operable in dependence upon that data to activate that selected row line;

input/output circuitry connected to the said column lines and having a plurality of control inputs associated respectively with predetermined different groups of the said column lines; and

column group selection means connected for receiving externally-applied selection data designating a selected one of the said control inputs, and operable in dependence upon that data to apply a column group selection signal to the said selected one of the control inputs;

the said input/output circuitry including a plurality of input/output lines, equal in number to the column lines of each of the said different groups, and being operable upon receipt of such a column group selection signal to connect the column lines of the particular group that is associated with the selected control input respectively to the said input/output lines, thereby to permit parallel transfer of data bits between the said input/output lines and those memory cells of the said plurality that are connected with the said selected row line and are also connected respectively with the column lines of the said particular group;

characterised in that each of the said input/output lines is provided with an individual set of gating units that can be activated, by application thereto of such column group selection signals, to connect respective column lines to the input/output line concerned, and each of the said control inputs is connected to an individual group of the said gating units, which group is made up of just one gating unit from each of the individual sets, thereby to define the group of column lines that is associated with the control input concerned, some of the column lines of that defined group being members also of another one of the said different groups of column lines but being connected to different input/output lines respectively when the control input associated with that other group is selected.

In an embodiment of the present invention, since the column groups are not mutually exclusive, individual "nibbles" of data can be selected with greater freedom than in a prior art device. To enhance such freedom of choice, it may be desired to access a "nibble" of consecutive memory cells bridging two different row lines, but it will be appreciated that problems can arise if two row lines of a single matrix are activated simultaneously.

To address this difficulty, in a preferred embodiment of the invention the memory cells of the device are arranged in two separate matrices of rows and columns, thereby permitting all the memory cells of a transitional group, some of which are connected with a row line of one matrix and the others of which are connected with an individually corresponding row line of the other matrix, to be accessed simultaneously.

Reference will now be made, by way of example, to the accompanying drawings, in which:

Fig. 1 is a block diagram of a conventional computer system including a conventional semiconductor memory device:

Fig. 2 is a diagram illustrating addresses and operands stored in the addresses;

Figs. 3a to 3d are timing charts showing the memory data read operation of the semiconductor memory device shown in Fig. 1;

Fig. 4 is a circuit diagram of an address-multiplex type semiconductor memory device embodying the present invention;

Figs. 5a to 5d are timing charts showing the memory data read operation of the semiconductor memory device shown in Fig. 4;

Fig. 6 is a detailed circuit diagram of parts of the semiconductor memory device shown in Fig. 4;

Fig. 7 is a circuit diagram of of a non-address-multiplex type semiconductor memory device embodying the present invention; and

Figs. 8a to 8d are timing charts showing the memory data read operation of the semiconductor memory device shown in Fig. 7.

Before describing preferred embodiments of the present invention, an explanation will be given of the prior art for reference.

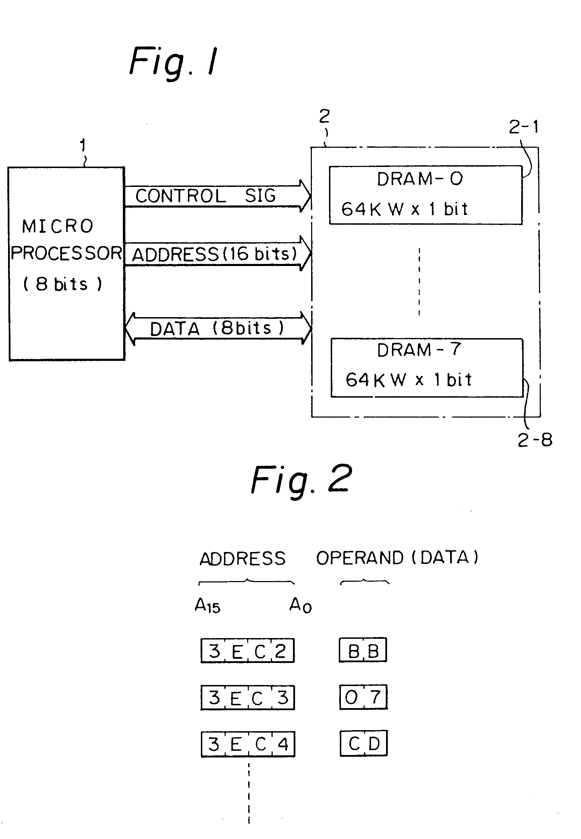

Figure 1 is a block diagram of a conventional computer system. The computer system includes a microprocessor 1 and a random access memory (RAM) 2. The microprocessor 1 is an 8 bits type. The RAM 2 consists of eight dynamic-random access memory device chips (D-RAMs) 2-1 to 2-8, each having a 64 K words x 1 bit memory capacity.

Figure 2 is a view illustrating addresses in the RAM 2 of Fig. 1, and operands stored in the corresponding addresses. In Fig. 2, each address is defined by four digits, each being hexadecimal format, and thus is formed by 16 bits: $A_0$ to $A_{15}$.

Note, in general, each digit may contain numerals 0 to 15, however, in this description, numerals 10 to 15 are represented by "A", "B", "C", "D", "E" and "F", for convenient representation as one digit. Each operand has a two digits-hexadecimal format and is formed by 8 bits. However, a complete operand for execution as an operation consists of a plurality of operands, such as a conbination of three operands "BB", "07", and "CD" as shown in Fig. 2. Accordingly, before executing an instruction, the microprocessor 1 must read a plurality of operands forming a complete operand to be just executed from the RAM 2.

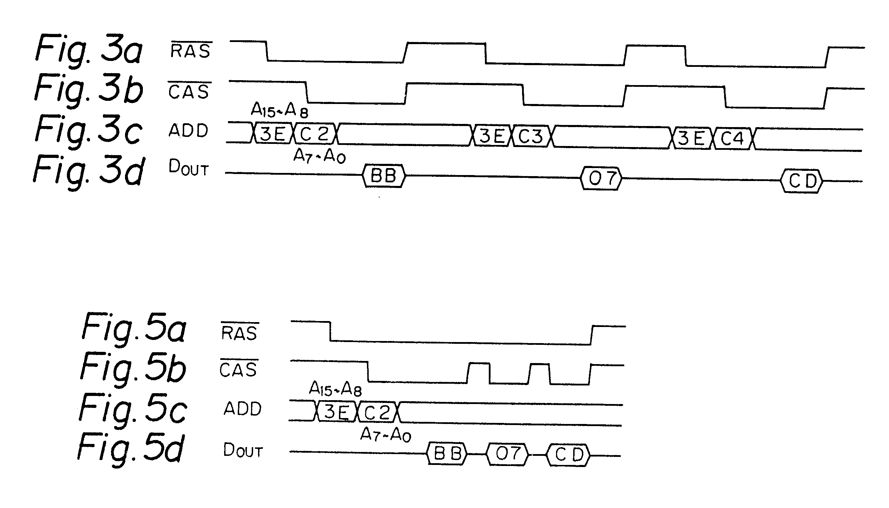

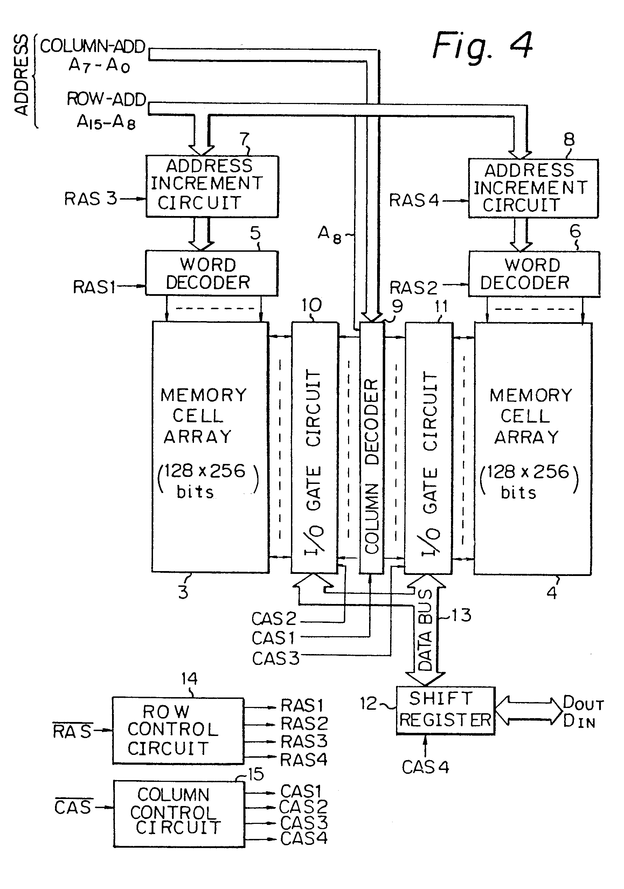

The above read operation will now be explained with reference to Figs. 3a to 3d.

The microprocessor 1 transmits an address signal ADD, consisting of a row-address "3E" stored in bits A16 to A8 and a column-address "C2" stored in bits $A_7$ to $A_0$ , to the RAM 2 as shown in Fig. 3C. A D-RAM controller (not shown) provided in the RAM unit 2 transmits an inverted row-address strobe signal $\overline{RAS}$, which is part of the control signal shown in Fig. 1, to the RAM 2 as shown in Fig. 3a, in response to the control signal from the microprocessor 1. In response to a trailing edge of the $\overline{RAS}$ signal, the RAM 2 reads the above row-address "3E" therein. The D-RAM controller also transmits an inverted column address strobe signal $\overline{CAS}$, which is also a part of the control signal shown in Fig. 1, to the RAM 2 as shown in Fig. 3b. In response to a trailing edge of the $\overline{CAS}$ signal, the RAM 2 reads the above column address "C2" therein. In the RAM 2, an access operation is carried out in response to the input address signal of "3EC2", and operand data "BB" stored in the address "3EC2" is output from the RAM 2 as an output data $D_{OUT}$, as shown in Fig. 3d. After completing the reading of the operand data, the D-RAM controller restores the $\overline{RAS}$ and $\overline{CAS}$ signals to a high level state.

The above operations can be continuously effected to read the operand data "07" stored in the address "3EC3" and the operand data "CD" stored in the address "3EC4", into the microprocessor 1.

The microprocessor 1 then combines the above read operand data and executes an instruction by the combined operand.

The above read operation can be applied to a data read and store operation for continuously reading and storing a plurality of consecutive data.

As can be understood from the above description, the requirement of a continuous plurality of operation sets for continuous data access, on one hand, results in a simple circuit construction in the computer system, but on other hand, limits high speed access for continuous data access. In the computer system, continuous accessing of a plurality of data upon one access request is required rather than a single data access. Accordingly, the conventional computer system cannot provide a high speed data access.

Preferred embodiments of the present invention will now be described with reference to the accompanying drawings.

Figure 4 is a circuit diagram of an address-multiplex type semiconductor memory device embodying the present invention. In Fig. 4, the semiconductor memory device includes two separate memory cell arrays 3 and 4 each having a 128 x 256 bits capacity, word decoders (row selection means) 5 and 6 cooperating with the memory cell arrays 3 and 4, and address increment circuits 7 and 8 provided at input portions of the word decoders 5 and 6. The semiconductor memory device also includes a column decoder (column group selection means) 9, an input and output (I/O) gate circuit 10 connected between the memory cell array 3 and the column decoder 9, an I/O gate circuit 11 connected between the memory cell array 4 and the column decoder 9, and a shift register 12 connected to the I/O gate circuits 10 and 11 through a data bus 13. The semiconductor memory device further includes a row control circuit 14 and a column control circuit 15.

In Fig. 4, the microprocessor and the D-RAM controller are omitted. However, the semiconductor memory device receives an address signal consisting of a row-address (row selection data) expressed by two hexadecimal digits by using bits $A_8$ to $A_{15}$, a column-address expressed by two hexadecimal digits by using bits $A_0$ to $A_7$, an inverted row-address-strobe signal $\overline{RAS}$, and an inverted column-address-strobe signal $\overline{CAS}$, from a D-RAM controller (not shown). The row-address is supplied to the address increment circuits 7 and 8, and the column-address is supplied to the column decoder 9. The $\overline{RAS}$ signal is once received at the row control circuit 14 to control a row address system and to generate a plurality of internal timing control signals RAS1 to RAS4 for controlling the word decoders 5 and 6 and the address increment circuits 7 and 8, respectively. The $\overline{CAS}$ signal is also once received at the column control circuit 15 to control a column address system and to generate a plurality of internal timing control signals CAS1 to CAS4 for controlling the column decoder 9 and the I/O gate circuits 10 and 11. In the following description, to simplify the description, the above RAS1 to RAS4 signals are referred to as the $\overline{RAS}$ signal, and the above CAS1 to CAS4 signals are referred to as the $\overline{CAS}$ signal.

The semiconductor memory device outputs data to the microprocessor through the shift register 12, when a read access request is received from the microprocessor. On the other hand, the semiconductor memory device inputs data at the Shift register 12 from the D-RAM controller when the microprocessor 1 requests a data store.

In the embodiment of Fig. 4, the memory cell array 3 stores data for even row addresses, and the memory cell array 4 stores data for odd row addresses. When the lowest bit $A_8$ of the row address is low, indicating an even row address, for example when the row address is "3E", the row address "3E" is supplied to the word decoder 5 through the address increment circuit 7 as is, whereby a word line for the memory cell array 3, designated by the row address, i.e. a word address "3E", may be selected. At the same time, the row address "3E" is supplied to the address increment circuit 8 and is added by one therein. The added row address "3E + 1" is supplied to the word decoder 6. A word line for the memory cell array 4, designated by the word address "3E + 1 = 3F" may be selected. Conversely, when the lowest bit $A_8$ of the row address is high, indicating an odd row address, the above mentioned relation for word line selection is reversed.

The operation of the semiconductor memory device will now be described with reference to Figs. 5a to 5d. In the following description, it is assumed that eight memory devices are used to form a memory unit as in Fig. 1, so that operand data as in Fig. 2 can be read out from the unit in accordance with the address as in Fig. 2, though only one memory device is illustrated in Fig. 4.

The microprocessor transmits an address signal consisting of a row-address "3E" and a column-address "C2" to the semiconductor memory device, as shown in Fig. 5C. The D-RAM controller transmits a $\overline{RAS}$ signal to the semiconductor memory device, as shown in Fig. 5a. In response to a trailing edge of the $\overline{RAS}$ signal, the row address "3E" is received at the address increment circuit 7 and is transmitted to the word decoder 5. Simultaneously, the row address "3E" is received at the address increment circuit 8 and is added by one therein. The added row address "3E + 1 = 3F" is transmitted to the word decoder 6. The D-RAM controller also transmits a $\overline{CAS}$ signal to the semiconductor memory device, as shown in Fig. 5b. In response to the trailing edge of the $\overline{CAS}$ signal, the column address "C2" is received at the column decoder 9. In addition, the lowest bit $A_8$ of the row address is received at the column decoder 9.

A word line corresponding to the row address "3E" in the word decoder 5 to the memory cell array 3 and a word line corresponding to the row address "3E + 1 = 3F" in the word decoder 6 to the memory cell array 4 are selected. A bit line to the memory cell array 3, corresponding to the column address "C2" is selected by the column decoder 9 and is connected to one signal (input/output) line of the data bus 13 by the I/O gate circuit 10. The I/O gate circuit 10 also connects a plurality of bit lines, e.g. 3 lines, subsequent to the above selected bit line to a plurality of subsequent data (input/output) lines, e.g. 3 lines, in the data bus 13. As a result, 4 bits of data stored in the address from "3EC2" to "3EC5" are read out in parallel and are stored in the shift register 12. The data obtained from the addressed column "C2" is output as one bit of the data "BB", while the $\overline{CAS}$ signal is maintained at a low level. Upon completion of this read operation for the data "BB", the D-RAM controller changes the $\overline{CAS}$ signal to a high level, as shown in Fig. 5b, whereby the one bit read out data of the data "BB" is reset and at the same time the data stored in the shift register 12 is serially shifted from the shift register 12 and received at the microprocessor as read-out data $D_{OUT}$.

In order to obtain the next column address data, the D-RAM controller changes the $\overline{CAS}$ signal to a low level state, as shown in Fig. 5b. Upon detecting the trailing edge of the $\overline{CAS}$ signal, the next column address data for "07" is output from the memory device. The succeeding two column data are similarly obtained by repetitively changing the $\overline{CAS}$ signal. The D-RAM controller then changes the $\overline{RAS}$ signal to a high level state to terminate the consecutive read operation.

Comparing the embodiment with the prior art system set forth before, the embodiment substantially reduces the access time for a consecutive read operation due to the elimination of transmission of the address data and the RAS signal for every read operation from the microprocessor 1 and the D-RAM controller to the semiconductor memory device.

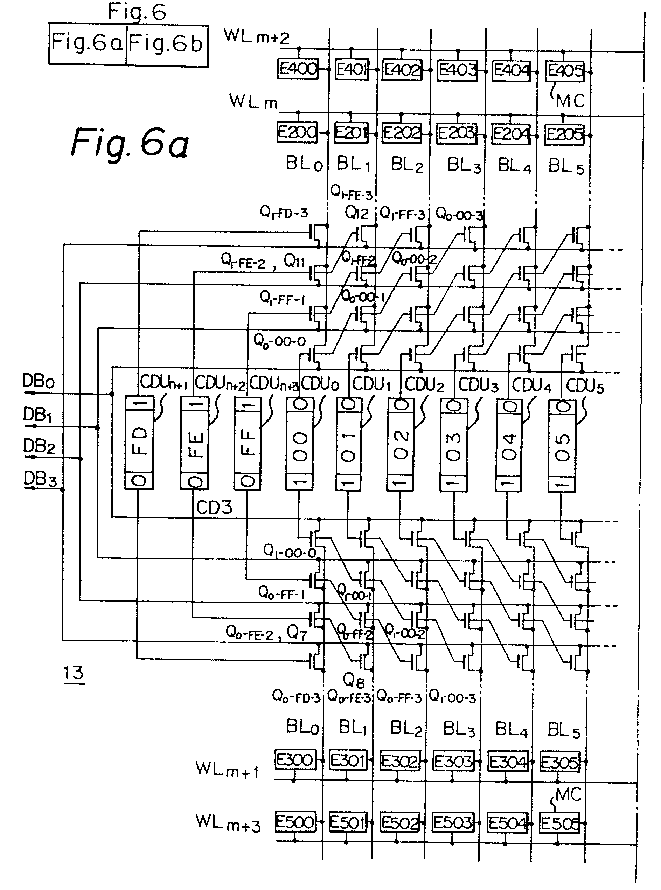

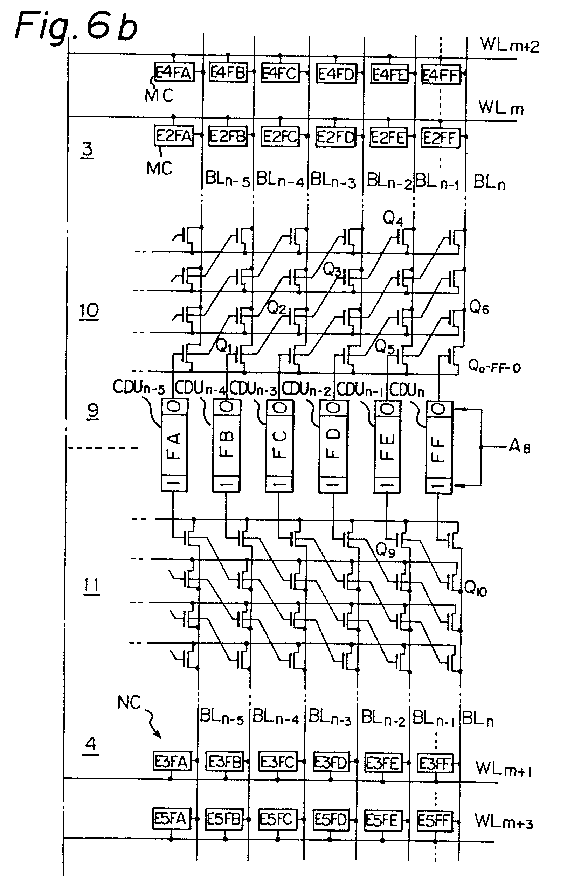

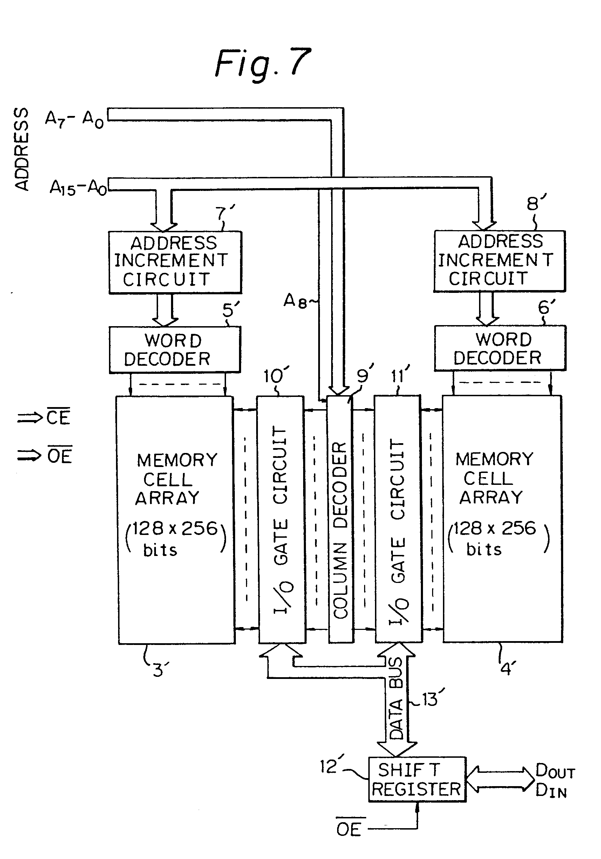

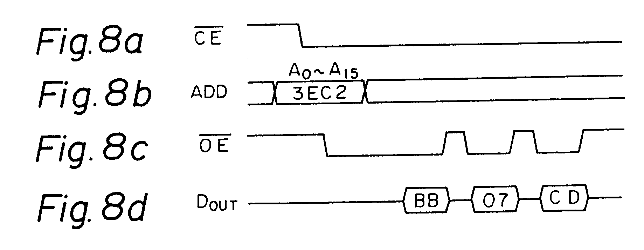

By transmitting a first address signal and the $\overline{RAS}$ and $\overline{CAS}$ signals for a first read access request and only the $\overline{CAS}$ signal for the subsequent read access request, the microprocessor reads consecutive data until the $\overline{RAS}$ signal is changed to a high level state. The microprocessor 1, of course, reads only one set of data in the manner of the prior art shown in Figs. 3a to 3d. The above features of the embodiment can be applied to a data store operation to the semiconductor memory device. In this case, the data to be stored is applied to the shift register 12 from the microprocessor serially as input data $D_{IN}$, and is stored to the corresponding address in the memory cell array 3 or 4 through the data bus 13, the I/O gate circuit 10 or 11, and the bit lines to the memory cell array 3 or 4. A more specific aspect of the above embodiment referred to in Figs. 4 and 5a to 5d will now be described with reference to Fig. 6.

In Fig. 6, memory cell arrays 3 and 4, input and output (I/O) gate circuits 10 and 11, and a column decoder 9 correspond to those of Fig. 4. Other circuit elements shown in Fig. 4 are omitted here.

The memory cell array 3 includes a plurality of memory cells MC connected between a plurality of bit lines (Column lines) $BL_0$, $BL_1$, ..., $BL_n$ and a plurality of word lines (row lines) $WL_0$, $WL_2$, ..., $WL_m$, $WL_{m+2}$,... (m: even). The memory cell array 4 also includes a plurality of memory cells MC connected between a plurality of bit lines (further column lines) $BL_0$, $BL_1$, ..., $Bl_n$ and a plurality of word lines (further row lines) $WL_1$, $WL_3$, ..., $WL_{m+1}$, $WL_{m+3}$, .... Each four digits-hexadecimal number in each memory cell represents an address thereto. The data bus 13 includes four parallel data lines $DB_0$, $DB_1$, $DB_2$ and $DB_3$. The I/O gate circuit 10 includes a plurality of transfer-gate transistors (gating units) connected between the data lines $DB_0$ to $DB_3$ and the bit lanes $BL_0$ to $BL_n$ to the memory cell array 3 and controlled by the column decoder 9. The I/O gate circuit 11 also includes a plurality of transfer-gate transistors connected between the data lines $DB_0$ to $DB_3$ and the bit lines $BL_0$ to $BL_n$ to the memory cell array 4 and controlled by the column decoder 9.

The column decoder 9 includes a plurality of column decoder units $CDU_0$ to $CDU_n$ provided correspondingly to columns, i.e., bit lines. In addition, the column decoder 9 includes three additional column decoder units $CDU_{n+1}$, $CDU_{n+2}$, and $CDU_{n+3}$. Each of the column decoder units $CDU_0$ to $CDU_n$ and $CDU_{n+1}$ to $CDU_{n+3}$ receives the $A_8$ bit of the address signal representing an odd or even row-address to select the corresponding transfer-gate transistors of the I/O gate circuit 10 or 11. However, the above selection of the additional column decoder units $CDU_{n+1}$ to $CDU_{n+3}$ by the $A_8$ bit of the address signal is the reverse of that of the column decoder units $CDU_0$ to $CDU_n$, as shown in Fig. 6. When the word address bit $A_8$ is "0" and the column address is "00", the column

decoder unit $CDU_0$ turns ON, by application thereto of a column group selection signal, a group of transfer-gate transistors made up of the transfer-gate transistor $Q_{0-00-0}$ in the I/O gate circuit 10 connected between the bit line $BL_0$ to the memory cell array 3 and the data line $DB_0$, the transistor $Q_{0-00-1}$ between the bit line $BL_1$ and the data line $DB_1$, the transistor $Q_{0-00-2}$ between the bit line $BL_2$ and the data line $DB_2$, and the transistor $Q_{0-00-3}$ between the bit line $BL_3$ and the data line $DB_3$, simultaneously On the other hand, when the word address bit $A_8$ is "1" and the column address is "00", the column decoder unit $CDU_0$ turns ON the transistors $Q_{1-00-0}$, $Q_{1-00-1}$, $Q_{1-00-2}$ and $Q_{1-00-3}$ in the I/O gate circuit 11. In this way, each of the column decoder units $CDU_0$ to $CDU_n$ connects a group of four bit (column) lines including the selected column, for example column "00", connected to the memory cell array 3 or 4 corresponding to the word address bit $A_8$, to the corresponding data lines $DB_0$ to $DB_3$. The additional column decoder unit $CDU_{n+1}$ controls the transistor $Q_{1-FD-3}$ in the I/O gate circuit 10, connected between the bit line $BL_0$ to the memory cell array 3 and the data line $DB_3$, on the transistor $Q_{0-FD-3}$ in the I/O gate circuit 11, connected between the bit line $BL_0$ to the memory cell array 4 and the data line $DB_3$, by the word address bit $A_8$. The additional column decoder unit $CDU_{n+2}$ controls the transistors $Q_{1-FE-2}$, i.e. $Q_{11}$, and $Q_{1-FE-3}$, i.e. $Q_{12}$, in the I/O gate circuit 10 or the transistors $Q_{0-FE-2}$, i.e. $Q_7$, and $Q_{0-FE-3}$, i.e. $Q_8$, in the I/O gate circuit 11. The additional column decoder unit $CDU_{n+3}$ controls the transistors $Q_{1-FF-1}$, $Q_{1-FF-2}$, and $Q_{1-FF-3}$ in the I/O gate circuit 10 or the transistors $Q_{0-FF-1}$, $Q_{0-FF-2}$, and $Q_{0-FF-3}$ in the I/O at circuit 11.

In Fig. 6, note that certain ones of the column decoder units are activated in pairs, i.e. $CDU_{n-2}$ and $CDU_{n+1}$ for the column address "FD", $CDU_{n-1}$ and $CDU_{n+2}$ for the column address "FE", and $CDU_n$ and $CDU_{n+3}$ for the column address "FF". Accordingly, when, for example, the column address is "FF", the column decoders $CDU_n$ and $CDU_{n+3}$ operate simultaneously. In addition, when the word address bit $A_8$ is "0", the transfer-gate transistor $Q_{0-FF-0}$ in the I/O gate circuit 10 can be turned ON by the column decoder unit $CDU_n$ and three transfer-gate transistors $Q_{0-FF-1}$, $Q_{0-FF-2}$, and $Q_{0-FF-3}$ in the I/O gate circuit 11 can be turned ON by the column decoder unit $CDU_{n+3}$. As can be seen from the above, the additional column decoder units $CDU_{n+1}$ to $CDU_{n+3}$ are provided to take a continuation of column addresses from the memory cell array 3 to the memory cell array 4, and vice versa. In order to obtain the continuation of column addresses, a sequence of word lines is also defined alternatively between the memory cell arrays 3 and 4, i.e., as $WL_m$, $WL_{m+2}$ in the memory cell array 3

and $WL_{m+1}$, $WL_{m+3}$ in the memory cell array 4 in Fig. 6.

The operation of the circuit shown in Fig. 6 will now be described.

When the start address is "E2FB", that is the word address is "E2" and the column address "FB", and thus the address bit $A_8$ is also "0", the word line WL (m = "E2") in the memory cell array 3 is selected in response to the trailing edge of the $\overline{RAS}$ signal. Also, the column decoder unit $CDU_{n+4}$ is selected in response to the trailing edge of the $\overline{CAS}$ signal. The transfer-gate transistors $Q_1$, $Q_2$, $Q_3$, and $Q_4$ in the I/O gate circuit 10, constituting a group of such transistors, are turned ON by the column decoder unit $CDU_{n-4}$. The bit lines $BL_{n-4}$, $BL_{n-3}$, $BL_{n-2}$, and $BL_{n-1}$ to the memory cell array 3, constituting a group of bit lines, are respectively connected to the data lines $DB_0$, $DB_1$, $DB_2$, and $DB_3$. As a result, data in four memory cell at the addresses "E2FB", "E2FC", "E2FD", and "E2FE" is read from the memory cell array 3 and is stored in the shift register 12, shown in Fig. 4, in parallel. The stored data is serially output to the microprocessor in response to the change of the $\overline{CAS}$ signal. Consequently, four consecutive pieces of data stored in the above consecutive addresses are read in the microprocessor.

When the start address is "E2FE", i.e., the word address is "E2" and the column address is "FE", and accordingly, the address bit $A_8$ is "0", the word line $WL_m$ (m = "E2") in the memory cell array 3 is selected in response to the trailing edge of the $\overline{RAS}$ signal. The column decoder unit $CDU_{n-1}$ is selected in response to the trailing edge of the $\overline{CAS}$ signal. At the same time, the additional column decoder unit $CDU_{n+2}$ is also selected. The transfer-gate transistors $Q_5$ and $Q_6$ in the I/O gate circuit 10 are then turned ON by the column decoder unit $CDU_{n-1}$; the transfer-gate transistor $Q_7$, i.e., $Q_{0-FF-0}$, and $Q_8$, i.e., $Q_{0-FE-1}$, in the I/O gate circuit 11 are turned ON by the column decoder unit $CDU_{n+2}$; the transistors $Q_5$ to $Q_8$ constituting a transitional group of transistors made up of two transistors from the I/O circuit 10 and two transistors from the I/O circuit 11. Accordingly, the final bit lines $BL_{n-1}$ and $BL_n$ in the memory cell array 3 are respectively connected to the data lines $DB_0$ and $DB_1$, and the initial two bit lines $BL_0$ and $BL_1$ in the memory cell array 4 are respectively connected to the data lines $DB_2$ and $DB_3$, the bit lines $BL_{n-1}$ and $BL_n$ of the array 3 and the bit lines $BL_0$ and $BL_1$ of the array 4 constituting a transitional group of bit (column) lines. As a result, data stored in the addresses "E2FE" and "E2FF" in the memory cell array 3 is read to the shift register 12 through the data lines $DB_0$ and $DB_1$. Simultaneously, data stored in the addresses "E300" and "E301" in the memory cell array 4 is read to the shift register 12 through the data lines $DB_2$ and $DB_3$. Consequently, four consecutive pieces of data stored in the addresses "E2FE" and "E2FF" in the memory cell array 3 and "E300" and E301" in the memory cell array 4 are serially read in the microprocessor, in response to the change of the $\overline{CAS}$ signal.

When the start address is "E3FE", i.e., the word address is "E3" and the column address is "FE", and accordingly, the address bit $A_8$ is "1", the word line $WL_{m+1}$ (m + 1 = "E3") in the memory cell array 4 is selected in response to the trailing edge of the $\overline{RAS}$ signal. The column decoder units $CDU_{n-1}$ and $CDU_{n+2}$ are selected in response to the trailing edge of the $\overline{CAS}$ signal. The transfergate transistors $Q_9$ and $Q_{10}$ in the I/O gate circuit 11 are turned ON by the column decoder unit $CDU_{n-1}$, and the transistors $Q_{11}$, i.e., $Q_{1-FE-0}$, and $Q_{12}$, i.e., $Q_{1-FE-1}$, are also turned ON by the additional column decoder unit $CDU_{n+2}$, the transistors $Q_9$ to $Q_{12}$ constituting a further transitional group of transistors. The bit lines $BL_{n+1}$ and $BL_n$ in the memory cell array 4 are connected to the data lines $DB_0$ and $DB_1$, and the bit lines $BL_0$ and $BL_1$ in the memory cell array 3 are connected to the data lines $DB_2$ and $DB_3$, the two final bit lines $BL_{n-1}$ and $BL_n$ of the array 4 and the two initial bit lines $BL_0$ and $BL_1$ of the array 3 constituting a further transitional group of bit lines. As a result, data stored in the addresses "E3FE" and "E3FF" in the memory cell array 4 is stored in the shift register 12 through the data lines $DB_0$ and $DB_1$. Simultaneously, data stored in the addresses "E400" and "E401" is stored in the shift register 12 through the data lines $DB_2$ and $DB_3$. Consequently, four consecutive pieces of data stored in the addresses "E3FE" and "E3FF" in the memory cell array 4 and "E400" and "E401" in the memory cell array 3 are serially read in the microprocessor in response to the change of the $\overline{CAS}$ signal.

In the above embodiment, shown in Fig. 6, the address increment circuits 7 and 8 in Fig. 4 are not shown. However, the function of the address increment circuits 7 and 8 set forth before with reference to Fig. 4 is achieved by construction of the word lines WL in the memory cell arrays 3 and 4 and selection of the bit lines BL to the memory cell arrays 3 and 4 using the transfer-gate transistors in the I/O gate circuits 10 and 11, which are turned ON by the column decoder units $CDU_0$ to $CDU_n$ and $CDU_{n+1}$ to $CDU_{n+3}$.

In Fig. 6, four bit lines $DB_0$ to $DB_3$ are shown and the shift register 12 has a capacity for storing four pieces of data, and thus four consecutive read or write operations may be performed. The number of additional column decoder units is defined as "the number of data lines minus one".

Figure 7 is a circuit diagram of a non-address multiplex type semiconductor memory device embodying the present invention.

The semiconductor memory device shown in Fig. 7 has a similar construction to that shown in Fig. 4. The semiconductor memory device includes two divided memory cell arrays 3' and 4', word decoders 5' and 6', address increment circuits 7' and 8', a column decoder 9', input and output gate circuits 10' and 11', a shift register 12, and a data bus 13'.

The operation of the semiconductor memory device shown in Fig. 7 will now be described with reference to Figs. 8a to 8d.

The microprocessor transmits an address signal "3EC2" to the semiconductor memory device. The D-RAM controller changes an inverted chip enable signal $\overline{CE}$ to low level. In response to a trailing edge of the $\overline{CE}$ signal, the semiconductor memory device receives the address signal "3EC2" and starts the memory access operation. The D-RAM controller changes the state of an inverted output enable signal $\overline{OE}$ to low level. As a result, output data "BB" in the address "3EC2" is output as output data $D_{OUT}$ from the shift register 12'. The $\overline{OE}$ signal is a signal controlling data output operation. When the $\overline{OE}$ signal is low level, the read data $D_{OUT}$ from the memory cell array 3' and 4' is output. By changing the level of the $\overline{OE}$ signal between low and high, subsequent data "07" and "CD" is read to the microprocessor.

The circuit shown in Fig. 6 may be applied to the semiconductor memory device shown in Fig. 7.

Many widely different embodiments of the present invention may be constructed without departing from the scope of the present invention. It should be understood that the present invention is not limited to the specific embodiments described in this specification, except as defined in the appended claims.

**Claims**

1. A semiconductor memory device including:

a plurality of memory cells arranged in a matrix (3) of columns, connected with respective column lines (BL) of the device, and rows connected with respective row lines ($WL_m$,$WL_{m+2}$,...) of the device;

row selection means (5) connected for receiving externally-applied row selection data designating a selected one of the said row lines, and operable in dependence upon that data to activate that selected row line;

input/output circuitry (10) connected to the said column lines (BL) and having a plurality of control inputs associated respectively with predetermined different groups ($BL_0$-$BL_3$,$BL_1$-$BL_4$...,$BL_{n-3}$-$BL_n$) of the said column lines (BL);

and

column group selection means (9) connected for receiving externally-applied selection data ($A_0$-$A_8$) designating a selected one of the said control inputs, and operable in dependence upon that data to apply a column group selection signal to the said selected one of the control inputs;

the said input/output circuitry (10) including a plurality of input/output lines (DB), equal in number to the column lines of each of the said different groups, and being operable upon receipt of such a column group selection signal to connect the column lines of the particular group that is associated with the selected control input respectively to the said input/output lines (DB), thereby to permit parallel transfer of data bits between the said input/output lines (DB) and those memory cells of the said plurality that are connected with the said selected row line and are also connected respectively with the column lines of the said particular group;

characterised in that each of the said input/output lines (DB) is provided with an individual set of gating units (Q) that can be activated, by application thereto of such column group selection signals, to connect respective column lines to the input/output line concerned, and each of the said control inputs is connected to an individual group (for example $Q_{0-00-0}$, $Q_{0-00-1}$, $Q_{0-00-2}$, $Q_{0-00-3}$) of the said gating units, which group is made up of just one gating unit from each of the individual sets, thereby to define the group ($BL_0$-$BL_3$) of column lines that is associated with the control input concerned, some (for example $BL_2$,$BL_3$) of the column lines of that defined group ($BL_0$-$BL_3$) being members also of another one (for example $BL_1$-$BL_4$) of the said different groups of column lines but being connected to different input/output lines ($DB_1$,$DB_2$) respectively when the control input associated with that other group ($BL_1$-$BL_4$) is selected.

2. A device as claimed in claim 1, including

a further plurality of memory cells arranged in a second matrix (4) of columns, connected with respective further column lines (BL) of the device, and rows connected with respective further row lines ($WL_{m+1}$,$WL_{m+3}$,...) of the device, the said row selection means (5) being operable also to activate a selected one of the said further row lines; and

further input/output circuitry (11) connected to the said further column lines and having a plurality of further control inputs associated respectively with predetermined different groups of the said further column lines, the further column lines of each of these groups being equal in number to the said input/output lines (DB);

said column group selection means (9) being operable, upon receipt of such selection data ($A_0$-$A_8$) designating a selected one of the said further control inputs, to apply a column group selection signal to the said selected one of those inputs; and the said further input/output circuitry (11) being operable upon receipt of that column group selection signal to connect the further column lines of the particular group that is associated with the selected further control input respectively to the said input/output lines (DB), thereby to permit parallel transfer of data bits between the said input/output lines (DB) and those memory cells of the said further plurality that are connected with the selected further row line and are also connected respectively with the further column lines of the last-mentioned particular group;

each of the said input/output lines (DB) being provided with a further individual set of gating units that can be activated, by application thereto of such column group selection signals, to connect respective further column lines to the input/output line concerned, and each of the said further control inputs being connected to an individual group of those gating units, which group is made up of just one gating unit from each of the said further individual sets, thereby to define the group of further column lines that is associated with the further control input concerned, some of those further column lines being members also of another one of the said different groups of further column lines but being connected to different input/output lines respectively when the further control input associated with that other group is selected;

the row and column group selection means (5,9) being operable selectively to activate both a selected one of the row lines ($WL_m$) of claim 1 and a corresponding one of the said further row lines ($WL_{m+1}$) and simultaneously to apply such a column group selection signal to a transitional group ($Q_5$,$Q_6$,$Q_7$,$Q_8$) of the gating units, made up of one or more gating units ($Q_5$,$Q_6$) from the said individual sets of claim 1 and one or more gating units ($Q_7$,$Q_8$) from the said further individual sets, thereby to cause a transitional group ($BL_{n-1}$,$BL_n$,$BL_0$,$BL_1$) of column lines, equal in number to the said input/output lines (DB) and made up of one or more ($BL_{n-1}$,$BL_n$) final column lines of the matrix (3) of claim 1 and one or more ($BL_0$,$BL_1$) initial further col-

umn lines of the said further matrix (4), to be connected respectively to the said input/output lines (DB).

3. A device as claimed in claim 2, wherein each of the said different groups of column lines is made up of four consecutive column lines in the matrix (3) of claim 1, and each of the said different groups of further column lines is made up of four consecutive further column lines in the said further matrix (4);

and wherein there are three such transitional groups of column lines made up respectively of the last three consecutive column lines $(BL_{n-2}, BL_{n-1}, BL_n)$ of the matrix (3) of claim 1 and the first further column line $(BL_0)$ of the said further matrix (4), the last two consecutive column lines $(BL_{n-1}, BL_n)$ of the matrix (3) of claim 1 and the first two consecutive further column lines $(BL_0, BL_1)$ of the said further matrix (4), and the last column line $(BL_n)$ of the matrix (3) of claim 1 and the first three consecutive further column lines $(BL_0, BL_1, BL_2)$ of the said further matrix (4).

4. A device as claimed in claim 2 or 3, wherein the row and column group selection means (5,9) are operable selectively to activate both a selected one of the said further row lines $(WL_{m+1})$ of the said further matrix (4) and a corresponding one of the said row lines $(WL_{m+2})$ of the matrix (3) of claim 1 and simultaneously to apply such a column group selection signal to a further transitional group $(Q_9, Q_{10}, Q_{11}, Q_{12})$ of the gating units, made up of one or more gating units $(Q_9, Q_{10})$ from the said further individual sets and one or more gating units $(Q_{11}, Q_{12})$ from the said individual sets of claim 1, thereby to cause a further transitional group $(BL_{n-1}, BL_n, BL_0, BL_1)$ of column lines, equal in number to the said input/output lines (DB) and made up of one or more $(BL_{n-1}, BL_n)$ final further column lines of the said further matrix (4) and one or more $(BL_0, BL_1)$ initial column lines of the matrix (3) of claim 1, to be connected respectively to the said input/output lines (DB).

5. A device as claimed in claim 4 read as appended to claim 3, wherein there are three such further transitional groups of column lines made up respectively of the last three consecutive further column lines $(BL_{n-2}, BL_{n-1}, BL_n)$ of the said further matrix (4) and the first column line $(BL_0)$ of the matrix (3) of claim 1, the last two consecutive further column lines $(BL_{n-1}, BL_n)$ of the said further matrix (4) and the first two consecutive column lines $(BL_0, BL_1)$ of the matrix (3) of claim 1, and the last further column line $(BL_n)$ of the said further matrix (4) and the first three consecutive column lines $(BL_0, BL_1, BL_2)$ of the matrix (3) of claim 1.

6. A device as claimed in claim 2, operable in such a manner that, as the row selection data is incremented repeatedly by a predetermined value, successively activated row lines are selected alternately from the matrix (3) of claim 1 and the said further matrix (4).

7. A device as claimed in any preceding claim, wherein the said input/output lines (DB) are connected to serial data transfer means (12) operable in response to repeated application thereto of a predetermined control signal (CAS) to accept data bits in succession, for delivery to the said input/output lines respectively during a write operation, or to output data bits, received from the respective input/output lines during a read operation, in succession.

**Revendications**

1. Un dispositif de mémoire à semiconducteurs comprenant :

un ensemble de cellules de mémoire disposées en une matrice (3) de colonnes, connectées à des conducteurs de colonne respectifs (BL) du dispositif, et de lignes connectées à des conducteurs de ligne respectifs $(WL_m, WL_{m+2}, ...)$ du dispositif;

des moyens de sélection de ligne (5) connectés de façon à recevoir des données de sélection de ligne appliquées de façon externe qui désignent l'un sélectionné des conducteurs de ligne, et qui peuvent fonctionner sous la dépendance de ces données de façon à activer le conducteur de ligne sélectionné;

un circuit d'entrée/sortie (10) connecté aux conducteurs de colonne (BL) et comportant un ensemble d'entrées de commande associées respectivement à différents groupes prédéterminés $(BL_0-BL_3, BL_1-BL_4, ..., BL_{n-3}-BL_n)$ des conducteurs de colonne (BL); et

des moyens de sélection de groupe de colonnes (9), connectés de façon à recevoir des données de sélection appliquées de façon externe $(A_0-A_8)$ qui désignent l'une sélectionnée des entrées de commande, et pouvant fonctionner sous la dépendance de ces données de façon à appliquer un signal de sélection de groupe de colonnes à l'entrée de commande sélectionnée;

le circuit d'entrée/sortie (10) comprenant un ensemble de conducteurs d'entrée/sortie (DB), en nombre égal au nombre de conducteurs de colonne de chacun des différents groupes, et réagissant à la réception d'un tel signal de sélection de groupe de colonnes en connectant respectivement aux conducteurs d'entrée/sortie (DB) les conducteurs de colonne du groupe particulier qui est associé à l'entrée de commande sélectionnée, pour permettre ainsi le transfert en parallèle de bits de données entre les conducteurs d'entrée/sortie (DB) et les cellules de mémoire de l'ensemble précité qui sont connectées au conducteur de ligne sélectionné et qui sont également connectées respectivement aux conducteurs de colonne du groupe particulier;

caractérisé en ce que chacun des conducteurs d'entrée/sortie (DB) comporte un jeu individuel d'éléments de transmission sélective (Q) qui peuvent être activés, par l'application de tels signaux de sélection de groupe de colonnes, de façon à connecter des conducteurs de colonne respectifs au conducteur d'entrée/sortie concerné, et chacune des entrées de commande est connectée à un groupe individuel (par exemple $Q_{0-00-0}$, $Q_{0-00-01}$, $Q_{0-00-2}$, $Q_{0-00-3}$) des éléments de transmission sélective, ce groupe étant constitué par seulement un élément de transmission sélective appartenant à chacun des jeux individuels, pour définir ainsi le groupe ($BL_0$-$BL_3$) de conducteurs de colonne qui est associé à l'entrée de commande concernée, certains (par exemple $BL_2$, $BL_3$) des conducteurs de colonne de ce groupe défini ($BL_0$-$BL_3$) étant également des membres d'un autre (par exemple $BL_1$-$BL_4$) des différents groupes de conducteurs de colonne, mais étant connectés respectivement à différents conducteurs d'entrée/sortie ($DB_1$, $DB_2$) lorsque l'entrée de commande associée à cet autre groupe ($BL_1$-$BL_4$) est sélectionnée.

2. Un dispositif selon la revendication 1, comprenant

un ensemble supplémentaire de cellules de mémoire disposées en une seconde matrice (4) de colonnes, connectées à des conducteurs de colonne supplémentaires respectifs (BL) du dispositif, et de lignes connectées à des conducteurs de ligne supplémentaires respectifs ($WL_{m+1}$, $WL_{m+3}$, ...) du dispositif, les moyens de sélection de ligne (5) pouvant également activer l'un sélectionné des conducteurs de ligne supplémentaires; et

un circuit d'entrée/sortie supplémentaire (11) connecté aux conducteurs de colonne supplémentaires et comportant un ensemble d'entrées de commande supplémentaires qui sont respectivement associées à différents groupes prédéterminés des conducteurs de colonne supplémentaires, les conducteurs de colonne supplémentaires de chacun de ces groupes étant en un nombre égal à celui des conducteurs d'entrée/sortie (DB);

les moyens de sélection de groupe de colonnes (9) réagissant à la réception des données de sélection ($A_0$-$A_8$) qui désignent l'une sélectionnée des entrées de commande supplémentaires, en appliquant un signal de sélection de groupe de colonnes à celle de ces entrées qui est sélectionnée; et le circuit d'entrée/sortie supplémentaire (11) réagissant à la réception de ce signal de sélection de groupe de colonnes en connectant respectivement aux conducteurs d'entrée/sortie (DB) les conducteurs de colonne supplémentaires du groupe particulier qui est associé à l'entrée de commande supplémentaire sélectionnée, pour permettre ainsi le transfert en parallèle de bits de données entre les conducteurs d'entrée/sortie (DB) et les cellules de mémoire de l'ensemble supplémentaire qui sont connectées au conducteur de ligne supplémentaire sélectionné et qui sont également connectées respectivement aux conducteurs de colonne supplémentaires du groupe particulier mentionné en dernier;

chacun des conducteurs d'entrée/sortie (DB) comportant un jeu individuel supplémentaire d'éléments de transmission sélective qui peuvent être activés, par l'application de tels signaux de sélection de groupe de colonnes, de façon à connecter des conducteurs de colonne supplémentaires respectifs au conducteur d'entrée/sortie concerné, et chacune des entrées de commande supplémentaires étant connectée à un groupe individuel de ces éléments de transmission sélective, ce groupe étant constitué par exactement une unité de transmission sélective appartenant à chacun des jeux individuels supplémentaires, pour définir ainsi le groupe de conducteurs de colonne supplémentaires qui est associé à l'entrée de commande supplémentaire concernée, certains des conducteurs de colonne supplémentaires étant également des membres d'un autre des différents groupes de conducteurs de colonne supplémentaires, mais étant connectés respectivement à différents conducteurs d'entrée/sortie lorsque l'entrée de commande supplémentaire associée à cet autre groupe est sélectionnée;

les moyens de sélection de groupe de lignes et de colonnes (5, 9) étant capables d'activer sélectivement à la fois l'un sélectionné des conducteurs de ligne ($WL_m$) de la re-

vendication 1 et l'un correspondant des conducteurs de ligne supplémentaires $(WL_{m+1})$, et d'appliquer simultanément un tel signal de sélection de groupe de colonnes à un groupe de transition $(Q_5, Q_6, Q_7, Q_8)$ des éléments de transmission sélective, qui est constitué par un ou plusieurs éléments de transmission sélective $(Q_5, Q_6)$ appartenant aux jeux individuels de la revendication 1 et par un ou plusieurs éléments de transmission sélective $(Q_7, Q_8)$ appartenant aux jeux individuels supplémentaires, pour connecter ainsi respectivement aux conducteurs d'entrée/sortie (DB) un groupe de transition $(BL_{n-1}, BL_n, BL_0, BL_1)$ de conducteurs de colonne, en nombre égal au nombre de conducteurs d'entrée/sortie (DB), et constitué par un ou plusieurs conducteurs de colonne finals $(BL_{n-1}, BL_n)$ de la matrice (3) de la revendication 1, et par un ou plusieurs conducteurs de colonne supplémentaires initiaux $(BL_0, BL_1)$ de la matrice supplémentaire (4).

3. Un dispositif selon la revendication 2, dans lequel chacun des différents groupes de conducteurs de colonne est constitué par quatre conducteurs de colonne consécutifs dans la matrice (3) de la revendication 1, et chacun des différents groupes de conducteurs de colonne supplémentaires est constitué par quatre conducteurs de colonne supplémentaires consécutifs dans la matrice supplémentaire (4);

et dans lequel il y a trois groupes de transition de conducteurs de colonne qui sont constitués respectivement par les trois derniers conducteurs de colonne consécutifs $(BL_{n-2}, BL_{n-1}, BL_n)$ de la matrice (3) de la revendication 1 et le premier conducteur de colonne supplémentaire $(BL_0)$ de la matrice supplémentaire (4), par les deux derniers conducteurs de colonne consécutifs $(BL_{n-1}, BL_n)$ de la matrice (3) de la revendication 1 et les deux premiers conducteurs de colonne supplémentaires consécutifs $(BL_0, BL_1)$ de la matrice supplémentaire (4), et par le dernier conducteur de colonne $(BL_n)$ de la matrice (3) de la revendication 1 et les trois premiers conducteurs de colonne supplémentaires consécutifs $(BL_0, BL_1, BL_2)$ de la matrice supplémentaire (4).

4. Un dispositif selon la revendication 2 ou 3, dans lequel les moyens de sélection de groupe de lignes et de colonnes (5, 9) sont capables d'activer sélectivement à la fois l'un sélectionné des conducteurs de ligne supplémentaires $(WL_{m+1})$ de la matrice supplémen-

taire (4) et l'un correspondant des conducteurs de ligne $(WL_{m+2})$ de la matrice (3) de la revendication 1, et d'appliquer simultanément un tel signal de sélection de groupe de colonnes à un groupe de transition supplémentaire $(Q_9, Q_{10}, Q_{11}, Q_{12})$ des éléments de transmission sélective, constitué par un ou plusieurs éléments de transmission sélective $(Q_9, Q_{10})$ appartenant aux jeux individuels supplémentaires, et par un ou plusieurs éléments de transmission sélective $(Q_{11}, Q_{12})$ appartenant aux jeux individuels de la revendication 1, pour connecter ainsi respectivement aux conducteurs d'entrée/sortie (DB) un groupe de transition supplémentaire $(BL_{n-1}, BL_n, BL_0, BL_1)$ de conducteurs de colonne, en un nombre égal au nombre des conducteurs d'entrée/sortie (DB), et constitué par un ou plusieurs conducteurs de colonne supplémentaires finals $(BL_{n-1}, BL_n)$ de la matrice supplémentaire (4), et par un ou plusieurs conducteurs de colonne initiaux $(BL_0, BL_1)$ de la matrice (3) de la revendication 1.

5. Un dispositif selon la revendication 4, considérée comme rattachée à la revendication 3, dans lequel il y a trois groupes de transition supplémentaires de conducteurs de colonne qui sont respectivement constitués par les trois derniers conducteurs de colonne supplémentaires consécutifs $(BL_{n-2}, BL_{n-1}, BL_n)$ de la matrice supplémentaire (4) et le premier conducteur de colonne $(BL_0)$ de la matrice (3) de la revendication 1, par les deux derniers conducteurs de colonne supplémentaires consécutifs $(BL_{n-1}, BL_n)$ de la matrice supplémentaire (4) et les deux premiers conducteurs de colonne consécutifs $(BL_0, BL_1)$ de la matrice (3) de la revendication 1, et par le dernier conducteur de colonne supplémentaire $(BL_n)$ de la matrice supplémentaire (4) et les trois premiers conducteurs de colonne consécutifs $(BL_0, BL_1, BL_2)$ de la matrice (3) de la revendication 1.

6. Un dispositif selon la revendication 2, capable de fonctionner d'une manière telle que, lorsque les données de sélection de ligne sont incrémentées de façon répétée d'une valeur prédéterminée, des conducteurs de ligne activés en succession sont sélectionnés alternativement dans la matrice (3) de la revendication 1 et dans la matrice supplémentaire (4).

7. Un dispositif selon l'une quelconque des revendications précédentes, dans lequel les lignes d'entrée/sortie (DB) sont connectées à des moyens de transfert de données en série (12) qui, lorsqu'on leur applique de façon répétée un signal de commande prédéterminé (CAS), acceptent des bits de données en succession, en vue de leur application aux conducteurs d'entrée/sortie respectifs pendant une opération d'écriture, ou bien émettent en succession des bits de données qui sont reçus à partir des conducteurs d'entrée/sortie respectifs pendant une opération de lecture.

**Patentansprüche**

1. Eine Halbleiterspeicheranordnung mit:

einer vielzahl von Speicherzellen, angeordnet in einer Matrix (3) von Spalten, die mit entsprechenden Spaltenleitungen (BL) der Anordnung verbunden sind, und Reihen, die mit entsprechenden Reihenleitungen ($WL_m$, $WL_{m+2}$, ...) der Anordnung verbunden sind;

einem Reihenauswahlmittel (5), welches zum Empfangen von extern angelegten Reihenauswahldaten, die eine ausgewählte der genannten Reihenleitungen bezeichnen, angeschlossen ist und in Abhängigkeit von jenen Daten betriebsfähig ist, um jene ausgewählte Reihenleitung zu aktivieren;

einer Eingangs-/Ausgangsschaltung (10), die mit den genannten Spaltenleitungen (BL) verbunden ist und eine vielzahl von jeweils mit vorher festgelegten verschiedenen Gruppen ($BL_0$-$BL_3$, $BL_1$-$BL_4$ ..., $BL_{n-3}$-$BL_n$) der genannten Spaltenleitungen (BL) zugeordnet Steuereingängen hat; und

einem Spaltengruppenauswahlmittel (9), welches zum Empfangen von extern angelegten Auswahldaten ($A_0$-$A_8$), die einen ausgewählten der genannten Steuereingänge bezeichnen, angeschlossen ist und in Abhängigkeit von jenen Daten betriebsfähig ist, um ein Spaltengruppenauswahlsignal an den genannten einen ausgewählten der Steuereingänge anzulegen;

wobei die genannte Eingangs-/Ausgangsschaltung (10) eine Vielzahl von Eingangs-/Ausgangsleitungen (DB), deren Anzahl gleich der der Spaltenleitungen von jeder der genannten verschiedenen Gruppen ist, enthält und bei Empfang eines derartigen Spaltengruppenauswahlsignals betriebsfähig ist, um die Spaltenleitungen der besonderen, dem ausgewählten Steuereingang zugeordneten Gruppe mit den entsprechenden genannten Eingangs-/Ausgangsleitungen (DB) zu verbinden, um dadurch eine parallele Übertragung von Datenbits zwischen den genannten Eingangs-/Ausgangsleitungen (DB) und jenen Speicherzellen der genannten Vielzahl zu gestatten, die mit der genannten ausgewählten Reihenleitung verbunden sind und auch jeweils mit den Spaltenleitungen der genannten besonderen Gruppe verbunden sind;

dadurch gekennzeichnet, daß jede der genannten Eingangs-/Ausgangsleitungen (DB) mit einem individuellen Satz von Gattereinheiten (Q) versehen ist, die durch Anlegen von derartigen Spaltengruppenauswahlsignalen an sie aktiviert werden können, um entsprechende Spaltenleitungen mit der betreffenden Eingangs-/Ausgangsleitung zu verbinden, und jeder der genannten Steuereingänge mit einer individuellen Gruppe (zum Beispiel $Q_{0-00-0}$, $Q_{0-00-1}$, $Q_{0-00-2}$, $Q_{0-00-3}$) der genannten Gattereinheiten verbunden ist, welche Gruppe aus genau einer Gattereinheit von jedem der individuellen Sätze besteht, um dadurch die Gruppe ($BL_0$-$BL_3$) der dem betreffenden Steuereingang zugeordneten Spaltenleitungen zu definieren, wobei einige (zum Beispiel $BL_2$, $BL_3$) der Spaltenleitungen jener definierten Gruppe ($BL_0$-$BL_3$) ebenfalls Glieder einer anderen (zum Beispiel $BL_1$-$BL_4$) der genannten verschiedenen Gruppen von Spaltenleitungen sind, aber jeweils mit verschiedenen Eingangs-/Ausgangsleitungen ($DB_1$, $DB_2$) verbunden sind, wenn der jener anderen Gruppe ($BL_1$-$BL_4$) zugeordnete Steuereingang ausgewählt ist.

2. Eine Anordnung nach Anspruch 1 mit einer weiteren Vielzahl von Speicherzellen, angeordnet in einer zweiten Matrix (4) von Spalten, die mit entsprechenden weiteren Spaltenleitungen (BL) der Anordnung verbunden sind, und Reihen, die mit entsprechenden weiteren Reihenleitungen ($WL_{m+1}$, $WL_{m+3}$, ...) der Anordnung verbunden sind, wobei das genannte Reihenauswahlmittel (5) auch betriebsfähig ist, um eine ausgewählte der genannten weiteren Reihenleitungen zu aktivieren; und

einer weiteren Eingangs-/Ausgangsschaltung (11), die mit den genannten weiteren Spaltenleitungen verbunden ist und eine vielzahl von weiteren, jeweils vorher festgelegten verschiedenen Gruppen der genannten weiteren Spaltenleitungen zugeordneten Steuereingängen hat, wobei die weiteren Spaltenleitungen jeder dieser Gruppen der Anzahl nach den genannten Eingangs-/Ausgangsleitungen (DB) gleich sind;

wobei das genannte Spaltengruppenauswahlmittel (9) bei Empfang von derartigen Auswahldaten ($A_0$-$A_8$), die einen ausgewählten der genannten weiteren Steuereingänge bezeichnen, betriebsfähig ist, um ein Spaltengruppenauswahlsignal an den genannten ausgewählten jener Eingänge anzulegen; und wobei die genannte weitere Eingangs-/Ausgangsschaltung (11) bei Empfang jenes Spaltengruppenauswahlsignals betriebsfähig ist, um die weiteren Spaltenleitungen der besonderen, dem entsprechenden ausgewählten weiteren Steuereingang zugeordneten Gruppe mit den genannten Eingangs-/Ausgangsleitungen (DB) zu verbinden, um dadurch eine parallele Übertragung von Datenbits zwischen den genannten Eingangs-/Ausgangsleitungen (DB) und jenen Speicherzellen der genannten weiteren Vielzahl zu gestatten, die mit der ausgewählten weiteren Reihenleitung verbunden sind und auch jeweils mit den weiteren Spaltenleitungen der letztgenannten besonderen Gruppe verbunden sind;

wobei jede der genannten Eingangs-/Ausgangsleitungen (DB) mit einem weiteren individuellen Satz von Gattereinheiten versehen ist, der durch Anlegen von derartigen Spaltengruppenauswahlsignalen an ihn aktiviert werden kann, um entsprechende weitere Spaltenleitungen mit der betreffenden Eingangs-/Ausgangsleitung zu verbinden, und wobei jeder der genannten weiteren Steuereingänge mit einer individuellen Gruppe jener Gattereinheiten verbunden ist, welche Gruppe aus genau einer Gattereinheit von jedem der genannten weiteren individuellen Sätze besteht, um dadurch die Gruppe von weiteren, dem betreffenden weiteren Steuereingang zugeordneten Spaltenleitungen zu definieren, wobei einige jener weiteren Spaltenleitungen ebenfalls Glieder einer anderen der genannten verschiedenen Gruppen von weiteren Spaltenleitungen sind, aber jeweils mit verschiedenen Eingangs-/Ausgangsleitungen verbunden sind,

wobei die Reihen- und Spaltengruppenauswahlmittel (5, 9) selektiv betriebsfähig sind, um sowohl eine ausgewählte der Reihenleitungen ($WL_m$) von Anspruch 1 als auch eine entsprechende der genannten weiteren Reihenleitungen ($WL_{m+1}$) zu aktivieren, und gleichzeitig, um solch ein Spaltengruppenauswahlsignal an eine Übergangsgruppe ($Q_5$, $Q_6$, $Q_7$, $Q_8$) der Gattereinheiten anzulegen, die aus einer oder mehr Gattereinheiten ($Q_5$, $Q_6$) von den genannten individuellen Sätzen von Anspruch 1 und einer oder mehr Gattereinheiten ($Q_7$, $Q_8$) von den genannten weiteren individuellen Sätzen besteht, um dadurch zu veranlassen, daß eine Übergangsgruppe ($BL_{n-1}$, $BL_n$, $BL_0$, $BL_1$) von Spaltenleitungen, deren Anzahl der der genannten Eingangs-/Ausgangsleitungen (DB) gleich ist und die aus einer oder mehr ($BL_{n-1}$, $BL_n$) Endspaltenleitungen der Matrix (3) von Anspruch 1 und einer oder mehr ($BL_0$, $BL_1$) weiteren Anfangsspaltenleitungen der genannten weiteren Matrix (4) besteht, jeweils mit den genannten Eingangs-/Ausgangsleitungen (DB) verbunden wird.

3. Eine Anordnung nach Anspruch 2, bei der jede der genannten verschiedenen Gruppen von Spaltenleitungen aus vier aufeinanderfolgenden Spaltenleitungen in der Matrix (3) von Anspruch 1 besteht, und jede der genannten verschiedenen Gruppen von weiteren Spaltenleitungen aus vier aufeinanderfolgenden weiteren Spaltenleitungen in der genannten weiteren Matrix (4) besteht;

und bei der drei derartige Übergangsgruppen von Spaltenleitungen vorhanden sind, die jeweils aus den letzten drei aufeinanderfolgenden Spaltenleitungen ($BL_{n-2}$, $BL_{n-1}$, $BL_n$) der Matrix (3) von Anspruch 1 und der ersten weiteren Spaltenleitung ($BL_0$) der genannten weiteren Matrix (4), den letzten zwei aufeinanderfolgenden Spaltenleitungen ($BL_{n-1}$, $BL_n$) der Matrix (3) von Anspruch 1 und den ersten zwei aufeinanderfolgenden weiteren Spaltenleitungen ($BL_0$, $BL_1$) der genannten weiteren Matrix (4) und der letzten Spaltenleitung ($BL_n$) der Matrix (3) von Anspruch 1 und den der genannten weiteren Matrix (4) und der letzten Spaltenleitung ($BL_n$) der Matrix (3) von Anspruch 1 und den ersten drei aufeinanderfolgenden weiteren Spaltenleitungen ($BL_0$, $BL_1$, $BL_2$) der genannten weiteren Matrix (4) bestehen.

4. Eine Anordnung nach Anspruch 2 oder 3, bei der die Reihen- und Spaltengruppenauswahlmittel (5, 9) selektiv betriebsfähig sind, um sowohl eine ausgewählte der genannten weiteren Reihenleitungen ($WL_{m+1}$) der genannten weiteren Matrix (4) als auch eine entsprechende der genannten Reihenleitungen ($WL_{m+2}$) der Matrix (3) von Anspruch 1 zu aktivieren, und gleichzeitig, um ein derartiges Spaltengruppenauswahlsignal an eine weitere Übergangsgruppe ($Q_9$, $Q_{10}$, $Q_{11}$, $Q_{12}$) von Gattereinheiten anzulegen, die aus einer oder mehr Gattereinheiten ($Q_9$, $Q_{10}$) von den genannten weiteren individuellen Sätzen und einer oder mehr Gattereinheiten ($Q_{11}$, $Q_{12}$) von den genannten individuellen Sätzen von Anspruch 1 besteht, um dadurch zu veranlassen, daß eine weitere Übergangsgruppe ($BL_{n-1}$, $BL_n$, $BL_0$, $BL_1$) von Spaltenleitungen, deren Anzahl der der genannten Eingangs-/Ausgangsleitungen (DB) gleich ist und die aus einer oder mehr ($BL_{n-1}$, $BL_n$) weiteren Endspaltenleitungen der genannten weiteren Matrix (4) und einer oder mehr ($BL_0$, $BL_1$) Anfangsspaltenleitungen der Matrix (3) von Anspruch 1 besteht, mit den entsprechenden genannten Eingangs-/Ausgangsleitungen (DB) verbunden wird.

13

5. Eine Anordnung nach Anspruch 4 in Verbindung mit Anspruch 3, bei der drei derartige weitere Übergangsgruppen von Spaltenleitungen vorhanden sind, die jeweils aus den letzten drei aufeinanderfolgenden weiteren Spaltenleitungen ($BL_{n-2}$, $BL_{n-1}$, $BL_n$) der genannten weiteren Matrix (4) und der ersten Spaltenleitung ($BL_0$) der Matrix (3) von Anspruch 1, den letzten zwei aufeinanderfolgenden weiteren Spaltenleitungen ($BL_{n-1}$, $BL_n$) der genannten weiteren Matrix (4) und den ersten zwei aufeinanderfolgenden Spaltenleitungen ($BL_0$, $BL_1$) der Matrix (3) von Anspruch 1 Spaltenleitungen ($BL_0$, $BL_1$, $BL_2$) der Matrix (3) von Anspruch 1 bestehen.

6. Eine Anordnung nach Anspruch 2, die auf solch eine Weise betriebsfähig ist, daß die sukzessiv aktivierten Reihenleitungen aus der Matrix (3) von Anspruch 1 und der genannten weiteren Matrix (4) abwechselnd ausgewählt werden, so wie die Reihenauswahldaten durch einen vorher festgelegten Wert wiederholt inkrementiert werden.

7. Eine Anordnung nach irgendeinem vorhergehenden Anspruch, bei der die genannten Eingangs-/Ausgangsleitungen (DB) mit einem seriellen Datenübertragungsmittel (12) verbunden sind, welches ansprechend auf das wiederholte Anlegen eines vorher festgelegten Steuersignals (CAS) daran betriebsfähig ist, um Datenbits nacheinander anzunehmen für die Lieferung während einer Schreiboperation an die genannten entsprechenden Eingangs-/Ausgangsleitungen, oder um Datenbits, die von den entsprechenden Eingangs-/Ausgangsleitungen während einer Leseoperation empfangen wurden, nacheinander auszugeben.

# Fig. 1

# Fig. 2

15

Fig. 3a RAS
Fig. 3b CAS
Fig. 3c ADD
Fig. 3d Dout

Fig. 5a RAS
Fig. 5b CAS
Fig. 5c ADD
Fig. 5d Dout

Fig. 4

Fig.6

| Fig.6a | Fig.6b |

Fig.6a

Fig. 6b

EP 0 174 845 B1

# Fig. 7

Fig.8a  $\overline{CE}$

Fig.8b  ADD  $A_0 \sim A_{15}$  3EC2

Fig.8c  $\overline{OE}$

Fig.8d  $D_{OUT}$  BB  O7  CD